# EUROPÄISCHE PATENTSCHRIFT

(11) **EP 3 642 866 B1**
(45) Veröffentlichungstag und Bekanntmachung des Hinweises auf die Patenterteilung: **18.10.2023**
(21) Anmeldenummer: 18730699.8
(22) Anmeldetag: 05.06.2018
(51) Int. Cl.: H01L 21/02, C30B 29/06, C30B 25/02, B24B 27/00, B24B 51/00, B24B 49/04, B24B 37/10, B24B 37/08, B24B 37/04, B24B 37/005, C30B 25/18, C30B 25/20, H01L 21/306, H01L 21/66

(54) **VERFAHREN ZUM BEARBEITEN EINER HALBLEITERSCHEIBE SOWIE HALBLEITERSCHEIBE**
METHOD FOR PROCESSING A SEMICONDUCTOR WAFER AND SEMICONDUCTOR WAFER
PROCÉDÉ DE TRAITEMENT D'UNE PLAQUETTE DE SEMI-CONDUCTEUR ET PLAQUETTE DE SEMI-CONDUCTEUR

(30) Priorität: 21.06.2017 DE 102017210423
(43) Veröffentlichungstag der Anmeldung: 29.04.2020
(73) Patentinhaber: Siltronic AG, 81677 München (DE)
(72) Erfinder: WELSCH, Stefan, 84570 Polling (DE); WEBER, Christof, 84489 Burghausen (DE); BEYER, Axel, 84489 Burghausen (DE)
(74) Vertreter: Staudacher, Wolfgang
(86) Internationale Anmeldenummer: PCT/EP2018/064735
(87) Internationale Veröffentlichungsnummer: WO 2018/234030

(56) Entgegenhaltungen:
- DE-A1-102005 045 339
- DE-A1-102008 045 534
- DE-A1-102015 224 933
- DE-B3-102007 021 729
- US-A1- 2008 036 040
- US-A1- 2009 269 861

## Beschreibung

Die vorliegende Erfindung betrifft ein Verfahren zum Bearbeiten einer Halbleiterscheibe, sowie eine Halbleiterscheibe.

### Stand der Technik

Halbleiterscheiben, insbesondere Siliziumscheiben, eignen sich beispielsweise für die Verwendung in der Halbleiterindustrie, insbesondere zur Fabrikation von hochintegrierten elektronischen Bauelementen wie beispielsweise Mikroprozessoren oder Speicherchips. Für die moderne Mikroelektronik werden Ausgangsmaterialien, sog. Substrate, mit hohen Anforderungen an globale und lokale Ebenheit, Randgeometrie, Dickenverteilung, einseiten-bezogene lokale Ebenheit, sog. Nanotopologie, und Defektfreiheit benötigt.

Um Halbleiterscheiben mit solchen Eigenschaften zu erhalten, können diese Halbleiterscheiben verschiedenen Bearbeitungsvorgängen unterzogen werden. Hierzu gehören insbesondere ein doppelseitiges Polieren (sog. DSP), bei dem beide Seiten einer Halbleiterscheibe gleichzeitig in einem Bearbeitungsschritt mittels zweier Arbeitsflächen materialabtragend bearbeitet werden und zwar vorzugsweise so, dass sich die vorder- und rückseitig während des Materialabtrags auf die Halbleiterscheibe wirkenden Bearbeitungskräfte im Wesentlichen ausgleichen und keine Zwangskräfte durch eine Führungsvorrichtung auf die Halbleiterscheibe ausgeübt werden, die Halbleiterscheibe also "frei schwimmend" (engl. "free floating") bearbeitet wird. Hierbei können insbesondere mehrere Halbleiterscheiben in einer oder mehreren sog. Läuferscheiben, die Ausnehmungen für die Halbleiterscheiben aufweisen, eingelegt und dann durch beidseitig auf die Halbleiterscheiben wirkende Kräfte poliert werden. Eine DSP-Bearbeitung von Siliziumscheiben ist beispielsweise beschrieben in US 2003/054650 A1 (Bildet die Basis für den Oberbegriff von Anspruch 1) und eine dafür geeignete Vorrichtung in DE 100 07 390 A1.

Als weiterer Bearbeitungsvorgang kommt ein chemisch-mechanisches Polieren (sog. CMP) in Betracht, wie es beispielswiese aus der DE 10 2008 045 534 B4 bekannt ist. Hierbei wird eine Halbleiterscheibe mittels eines Trägers auf ein Poliertuch (das sich auf einem Polierteller befinden kann) gedrückt und dann unter Druck meist rotierend bewegt. Durch die Verwendung eines geeigneten Poliermittels bzw. einer Poliermittelsuspension wird dann eine Seite der Halbleiterscheibe poliert.

Als weiterer Bearbeitungsvorgang kommt ein Beschichtungsvorgang in Betracht, wie er beispielsweise aus der DE 10 2005 045 339 A1 bekannt ist. Bei einem epitaktischen Beschichten von Halbleiterscheiben wird beispielsweise in einem Epitaxie-Reaktor ein Abscheidegas durch den Epitaxie-Reaktor geleitet, wodurch sich auf einer Oberfläche der Halbleiterscheiben epitaktisch Material abscheiden kann. Außer auf den Halbleiterscheiben scheidet sich das Material jedoch auch im Inneren des Epitaxie-Reaktors ab. Daher ist es üblicherweise notwendig, solche Rückstände, die sich während des Abscheidens auf Oberflächen im Epitaxie-Reaktor unkontrolliert abgelagert haben, von Zeit zu Zeit zu entfernen.

Um möglichst optimale Halbleiterscheiben zu erhalten, d.h. solche, die den oben genannten Anforderungen möglichst gut genügen, ist es üblich, jeden dieser Bearbeitungsvorgänge hinsichtlich der Betriebsparameter zu optimieren, um ein möglichst optimales Ergebnis bei jedem dieser Bearbeitungsvorgänge zu erhalten.

Vor diesem Hintergrund stellt sich die Aufgabe, eine Möglichkeit anzugeben, noch bessere Halbleiterscheiben, insbesondere hinsichtlich der Ebenheit ihrer Oberfläche, zu erhalten.

### Offenbarung der Erfindung

Erfindungsgemäß werden ein Verfahren, sowie eine Halbleiterscheibe mit den Merkmalen der unabhängigen Patentansprüche vorgeschlagen. Vorteilhafte Ausgestaltungen sind Gegenstand der Unteransprüche sowie der nachfolgenden Beschreibung.

Die Erfindung geht aus von einem Verfahren zum Bearbeiten einer Halbleiterscheibe mit drei Bearbeitungsvorgängen umfassend einen ersten Poliervorgang, bei dem die Halbleiterscheibe doppelseitig poliert wird (also dem sog. DSP), nachfolgend einen zweiten Poliervorgang, bei dem die Halbleiterscheibe chemisch-mechanisch poliert wird (also dem sog. CMP), und nachfolgend einen Beschichtungsvorgang, bei dem auf die Halbleiterscheiben epitaktisch eine Schicht abgeschieden wird.

Für diese einzelnen Bearbeitungsvorgänge können dabei geeignete Bearbeitungsvorrichtungen verwendet werden. Für den ersten Poliervorgang kommt dabei beispielsweise eine erste Poliervorrichtung in Betracht, die einen oberen und einen unteren, jeweils um eine gemeinsame Rotationsachse rotierbaren Polierteller, sowie zwischen dem oberen und dem unteren Polierteller angeordnete Läuferscheiben zur Aufnahme von Halbleiterscheiben aufweist. Den Halbleiterscheiben zugewandte Flächen des oberen und des unteren Poliertellers können jeweils plan und zueinander parallel ausgerichtet sein. Auf den Halbleiterscheiben zugewandten Flächen des oberen und des unteren Poliertellers kann dabei jeweils ein Poliertuch aufgebracht sein. Generell ist es dabei üblich, bei einem solchen Poliervorgang mehrere Halbleiterscheiben in einem Durchgang zu bearbeiten bzw. polieren.

Für den zweiten Poliervorgang kommt dabei beispielsweise eine zweite Poliervorrichtung in Betracht, die einen Polierteller mit darauf angeordnetem Poliertuch aufweist. Zudem kann ein Träger vorgesehen sein, mit dem eine Kraft auf eine Halbleiterscheibe, die auf dem Poliertuch liegt, aufgebracht werden kann. Dabei kann die Halbleiterscheibe mittels des Trägers, der insbesondere um eine eigene zentrale Achse rotieren kann, auf dem Poliertuch entlang bewegt werden. Dabei können ein geeignetes Poliermittel oder eine Poliermittelsuspension zugegeben werden. Bei einem solchen Poliervorgang wird dabei üblicherweise nur eine einzelne Halbleiterscheibe in einem Durchgang bearbeitet bzw. poliert.

Für den Beschichtungsvorgang kommt beispielsweise eine Beschichtungsvorrichtung, insbesondere ein Epitaxie-Reaktor, in Betracht, bei dem eine Halbleiterscheibe auf einen Suszeptor aufgebracht werden kann. Durch die Beschichtungsvorrichtung kann dann ein Abscheidegas zum Beschichten der Halbleiterscheibe geleitet werden. Zusätzlich kann vor einem Durchleiten von Abscheidegas ein Ätzgas durch die Beschichtungsvorrichtung geleitet werden, um etwaige Abscheidungen in der Beschichtungsvorrichtung zu entfernen. Bei einem solchen Beschichtungsvorgang ist es dabei durchaus üblich, nur eine einzelne Halbleiterscheibe in einem Durchgang zu beschichten.

Zwischen, vor bzw. nach diesen drei Bearbeitungsvorgängen können auch noch weitere Bearbeitungsvorgänge stattfinden, die jedoch keine oder zumindest keine wesentliche Auswirkung auf die Ebenheit der Halbleiterscheibe haben.

Erfindungsgemäß ist es nun vorgesehen, dass dafür, dass sich wenigstens ein Scheibenparameter nach Durchlaufen aller drei Bearbeitungsvorgänge in einem erwünschten Wertebereich befindet, wenigstens zwei Betriebsparameter, die zu verschiedenen der Bearbeitungsvorgänge gehören, in Abhängigkeit voneinander vorgegeben werden.

Insbesondere kann dies auch mittelbar geschehen, indem bei wenigstens einem der Bearbeitungsvorgänge wenigstens ein zugehöriger Betriebsparameter basierend auf einem Wert wenigstens eines Scheibenparameters nach Durchlaufen wenigstens eines anderen der Bearbeitungsvorgänge vorgegeben wird, wobei dieser Scheibenparameter wiederum von wenigstens einem Betriebsparameter dieses anderen der Bearbeitungsvorgänge abhängt. Auf diese Weise kann die genaue Abhängigkeit der Betriebsparameter untereinander durch beispielsweise Messung des Scheibenparameters erhalten werden.

Als Betriebsparameter sind dabei insbesondere verschiedene Größen, die bei dem jeweiligen Bearbeitungsvorgang eingestellt werden können, in Betracht zu ziehen. Dabei kann es sich beispielsweise um Drücke bzw. eine Druckverteilung bei einem Poliervorgang oder einen Volumen- oder Massenstrom von Abscheidegas bzw. Ätzgas beim Beschichtungsvorgang handeln. Insbesondere bei dem zweiten Poliervorgang kann die Druckverteilung dabei unterschiedliche Drücke für verschiedene Radien der Halbleiterscheibe umfassen, wie nachfolgend noch näher erläutert wird. Bei beiden Poliervorgängen können zudem auch Rotationsgeschwindigkeiten und/oder Polierdauern eingestellt werden.

Unter einem Scheibenparameter ist ein Parameter oder eine Größe zu verstehen, anhand welcher eine Halbleiterscheibe, insbesondere hinsichtlich ihrer Qualität, beurteilt werden kann. Für Beispiele solcher Scheibenparameter sei auf die noch folgenden Erläuterungen verwiesen.

Dabei wurde erkannt, dass durch Berücksichtigung von Wechselwirkungen zwischen den verschiedenen Bearbeitungsvorgängen deutlich bessere Ergebnisse, insbesondere hinsichtlich der Ebenheit der Halbleiterscheiben erzielt werden können, als bei Optimierung jedes einzelnen Bearbeitungsvorgangs für sich. Dies ist insbesondere darauf zurückzuführen, dass durch eine Betrachtung von Wechselwirkungen zwischen verschiedenen Bearbeitungsvorgängen insbesondere auch Bereiche für Betriebsparameter bei den einzelnen Bearbeitungsvorgängen berücksichtigt werden, die bei dem einzelnen Bearbeitungsvorgang für sich genommen aufgrund signifikanter Abweichungen zum Prozess-Optimum nicht in Betracht gezogen würden. So kann nun beispielsweise bei dem zweiten Poliervorgang ein stärkerer Abtrag von Material am äußeren Rand einer Halbleiterscheibe in Kauf genommen oder auch gezielt eingestellt werden, wenn bei dem späteren Beschichtungsvorgang am äußeren Rand ohnehin ein höherer Auftrag von Material auf die Halbleiterscheibe zu erwarten ist oder gezielt eingestellt werden kann. Auch kann in Abhängigkeit von einem gewünschten Wert des wenigstens einen Scheibenparameters nach einem nachfolgenden Bearbeitungsvorgang ein Betriebsparameter vorgegeben werden, wie später noch erläutert. Das Ergebnis eines Poliervorgangs soll dann beispielsweise nicht mehr sein, dass die Halbleiterscheibe möglichst flach ist, sondern dass sie für den nachfolgenden Bearbeitungsvorgang ein gutes Ausgangsprodukt, jedoch ggf. mit einem erwünschten Profil, darstellt.

Ebenso kann dem beim Beschichtungsvorgang auftretenden Umstand Rechnung getragen werden, dass Material im Randbereich abhängig vom Polarwinkel mit unterschiedlichen Geschwindigkeiten abgeschieden wird. So wächst beispielsweise auf einer {100}-orientierten Halbleiterscheibe aus einkristallinem Silizium mit einer Orientierungskerbe (notch), die eine <110>-Richtung kennzeichnet, eine epitaktische Schicht aus einkristallinem Silizium an Polarwinkel-Positionen von 0°, 90°, 180° und 270° schneller, als an Polarwinkel-Positionen, die zu den genannten Positionen um 45° versetzt liegen. Die 0°-Position bezeichnet die Notch-Position. Die Dicke der beschichteten Halbleitescheibe ist deshalb in vier Bereichen des Umfangs, die gleiche Abstände zueinander haben, größer, als in den dazwischen liegenden Bereichen (sog. Vierfach-Symmetrie).

Für jeden der drei Bearbeitungsvorgänge wird wenigstens ein Betriebsparameter des jeweiligen Bearbeitungsvorgangs vorgegeben, und zwar basierend auf wenigstens einem Scheibenparameter, der an der zu bearbeitenden Halbleiterscheibe ermittelt wird;
basierend auf einem Ist-Zustand einer Bearbeitungsvorrichtung, mit der der jeweilige Bearbeitungsvorgang durchgeführt wird; und
vorzugsweise basierend auf einer Optimierung der Scheibenparameter ESFQRₘₐₓ, SFQRₘₐₓ, ZDDₐᵥ und GBIR hinsichtlich deren Zustands nach dem Durchlaufen der drei Bearbeitungsvorgänge an Stelle einer Optimierung dieser Scheibenparameter hinsichtlich deren Zustands nach jedem einzelnen der drei Bearbeitungsschritte.

Die Erfinder schlagen also vor, Betriebsparameter für die Bearbeitungsvorgänge derart vorzugeben, dass die die Ebenheit charakterisierenden Scheibenparameter ESFQRₘₐₓ, SFQRₘₐₓ, ZDDₐᵥ und GBIR nach den drei Bearbeitungsvorgängen optimiert sind, also in einem Bereich von Zielwerten liegen.

Der wenigstens eine Scheibenparameter, der an der zu bearbeitenden Halbleiterscheibe ermittelt wird, wird vorzugsweise aus Rohdaten einer Ebenheitsmessung erhalten. Grundsätzlich eignen sich daher beispielsweise ESFQRₘₐₓ und SFQRₘₐₓ als zu ermittelnde Scheibenparameter. Vorzugsweise hat der zu ermittelnde Scheibenparameter die Eigenschaft, dass ihm Betrag und Vorzeichen der Abweichung von einer Referenz, beispielsweise einer Referenzebene oder einer Referenzgeraden zu entnehmen sind. Aus diesem Grund wird vorzugsweise ESFQDₐᵥ als der zu ermittelnde Scheibenparameter ausgewählt. Das Acronym ESFQD steht für "Edge Site Frontsurface-referenced least sQuares/Deviation" und der Index av bezeichnet den Mittelwert der ESFQD-Werte von Rand-Teilbereichen (edge sites) im Umfangsbereich der Halbleiterscheibe. Üblicherweise umfasst der Umfangsbereich 72 solcher Teilbereiche (Sektoren).

Auf die vorgeschlagene Weise können Halbleiterscheiben erhalten werden, die deutlich bessere Werte hinsichtlich der eingangs genannten Anforderungen aufweisen. Insbesondere wird eine Halbleiterscheibe zugänglich gemacht, deren ESFQRₘₐₓ-Wert bei einem Randausschluss von 2 mm, einer Randaufteilung in 72 Sektoren und einer Sektorlänge von 30 mm nicht größer als 10 nm ist, deren SFQRₘₐₓ-Wert bei einem Randausschluss von 2 mm und einer Site-Fläche von 26 mm x 8 mm nicht größer als 10 nm ist, deren ZDDₐᵥ-Wert an einer Radiusposition von 148 mm einen Betrag hat, der nicht größer als 10 nm/mm² ist, und deren GBIR-Wert bei einem Randausschluss von 2 mm nicht größer als 0,10 µm ist. Eine solche Halbleiterscheibe, insbesondere in Form einer einkristallinen Siliziumscheibe mit epitaktischer Schicht aus einkristallinem Silizium , ist auch Gegenstand der Erfindung. Die Halbleiterscheibe ist vorzugsweise {100}-orientiert oder {110}-orientiert und hat vorzugsweise einen Durchmesser von nicht weniger als 300 mm.

Mit ZDDₐᵥ ("Z-Height Double Differentiation") wird dabei der Mittelwert der Krümmung des Randbereichs einer Vorderseite der Halbleiterscheibe beschrieben. Die Vorderseite ist diejenige Seite, die mit einer epitaktischen Schicht beschichtet ist. SFQR steht dabei für "Site Frontsurface-referenced least sQuares/Range" und dessen Wert gibt die Flachheit der Halbleiterscheibe an. SFQRₘₐₓ bezeichnet den größten SFQR-Wert von Teilbereichen (sites), die keine Rand-Teilbereiche sind. Insbesondere werden damit positive und negative Abweichungen einer Oberfläche von einer ebenen Referenzfläche zusammengefasst. In der Regel werden dabei die Abweichungen jeweils für eine Fläche mit bestimmten Abmessungen an der Oberfläche der Halbleiterscheibe zur Berechnung herangezogen. ESFQR steht für "Edge Site Frontsurface-referenced least sQuares/Range " und dessen Wert ist ebenso wie der SFQR-Wert definiert, jedoch nur für Rand-Teilbereiche (ege sites) der Halbleiterscheibe. ESFQRₘₐₓ bezeichnet den größten ESFQR-Wert der Rand-Teilbereiche. GBIR steht für "Global Backside Indicated Reading". All diese Werte sind dabei besonders sensitiv hinsichtlich radialer und polarwinkelabhängiger Inhomogenitäten.

Definitionen und Messvorschriften für die genannten Scheibenparameter sind in den Normen SEMI M67 (ESFQR und ESFQD), SEMI M1, SEMI MF1530 und SEMI M49 (SFQR und GBIR) sowie SEMI M68 (ZDD) enthalten.

Es wird für jeden der Bearbeitungsvorgänge wenigstens ein zugehöriger Betriebsparameter basierend auf einem ermittelten Wert wenigstens eines Scheibenparameters nach Durchlaufen wenigstens eines vorausgehenden der Bearbeitungsvorgänge vorgegeben. Auf diese Weise können insbesondere etwaige nachteilige Werte mit einem nachfolgenden Bearbeitungsvorgang ausgeglichen werden, um so einen besonders guten Wert für den Scheibenparameter zu erhalten.

Der wenigstens eine Betriebsparameter, der zum ersten Poliervorgang gehört und eingestellt wird, wird vorzugsweise aus einer Gruppe ausgewählt, die einen Polierdruck, eine Polierdauer, eine Drehgeschwindigkeit eines oberen Poliertellers, eine Drehgeschwindigkeit eines unteren Poliertellers, eine Drehgeschwindigkeit eines inneren Antriebskranzes, eine Drehgeschwindigkeit eines äußeren Antriebskranzes, eine Temperatur des oberen Poliertellers, eine Temperatur des unteren Poliertellers, eine Zusammensetzung eines Poliermittels , einen Volumenstrom des Poliermittels, eine Temperatur des Poliermittels, einen pH-Wert des Poliermittels und eine Ziel-Differenz von Zentrums-Dicke der polierten Halbleiterscheibe und mittlerer Dicke der zum Polieren verwendeten Läuferscheibe (negative Ziel-Differenz = Unterstand (negative jut out), positive Ziel-Differenz = Überstand (positive jut out)) umfasst.

Besonders vorteilhaft ist es, wenn für den zweiten Poliervorgang der wenigstens eine zughörige Betriebsparameter basierend auf dem Wert des wenigstens einen Scheibenparameters nach Durchlaufen des ersten Poliervorgangs vorgegeben wird. Ebenso vorteilhaft ist es auch, wenn für den Beschichtungsvorgang der wenigstens eine zugehörige Betriebsparameter basierend auf dem Wert des wenigstens einen Scheibenparameters nach Durchlaufen des zweiten Poliervorgangs vorgegeben wird. Generell lassen sich auf diese Weise besonders flache bzw. ebene Halbleiterscheiben erzielen, wie sie insbesondere ohne Berücksichtigung von Resultaten übergreifend über die verschiedenen Bearbeitungsvorgänge nicht zu erreichen wären.

Es wird für jeden der Bearbeitungsvorgänge wenigstens ein zugehöriger Betriebsparameter basierend auf Zielwerten der Scheibenparameter ESFQRₘₐₓ, SFQRₘₐₓ, ZDDₐᵥ und GBIR nach Durchlaufen der drei Bearbeitungsvorgänge vorgegeben. Es lassen sich somit also nicht nur etwaige nachteilige Werte mit einem nachfolgenden Bearbeitungsvorgang ausgleichen, sondern es können auch gezielt Abweichungen vorgegeben werden, die sich mit einem der nachfolgenden Bearbeitungsvorgänge beispielsweise besonders gut wieder ausgleichen lassen.

Es ist von Vorteil, wenn für jeden der drei Bearbeitungsvorgänge der wenigstens eine zugehörige Betriebsparameter individuell für eine einzelne Halbleiterscheibe vorgegeben wird, insbesondere basierend auf einem Wert des wenigstens einen Scheibenparameters der jeweiligen Halbleiterscheibe nach Durchlaufen wenigstens eines anderen der Bearbeitungsvorgänge. Durch eine solche individuelle Einstellung bzw. Vorgabe von Betriebsparametern, insbesondere basierend auf einem Scheibenparameter, der vor dem jeweiligen Bearbeitungsvorgang an der zu bearbeitenden Halbleiterscheibe ermittelt wird bzw. basierend auf Zielwerten der Scheibenparameter ESFQRₘₐₓ, SFQRₘₐₓ, ZDDₐᵥ und GBIR nach Durchlaufen der drei Bearbeitungsvorgänge können deutlich ebenere bzw. flachere Halbleiterscheiben erhalten werden, als mit der bislang üblichen Vorgabe eines festen Bearbeitungsrezepts am jeweiligen Bearbeitungsschritt für eine Vielzahl von Halbleiterscheiben. Dies liegt beispielsweise auch darin begründet, dass sich mit der Bearbeitung einer Halbleiterscheibe auch die Bearbeitungsvorrichtung verändern kann, beispielsweise durch Abnutzung von Poliertüchern oder Ablagerung von Beschichtungsmaterial, was durch die individuelle Vorgabe im Rahmen dieser Erfindung besonders gut berücksichtigt werden kann.

Zweckmäßig ist es, wenn der Wert des wenigstens einen zu ermittelnden Scheibenparameters der jeweiligen Halbleiterscheibe gemessen und/oder anhand einer Auswertung (z.B. Mittelwert, Inter- und/oder Extrapolation) basierend auf einer Mehrzahl an Halbleiterscheiben ermittelt wird. Eine Messung mit einer geeigneten Messvorrichtung, beispielsweise durch kapazitive oder interferometrische Abtastung, kommt dabei insbesondere bei denjenigen Bearbeitungsvorgängen in Betracht, bei denen je Durchgang nur eine Halbleiterscheibe bearbeitet wird. Bei gleichzeitiger Bearbeitung mehrerer Scheiben kommt hingegen insbesondere auch eine (je nach Situation) Auswertung (z.B. Mittelwert, Inter- und/oder Extrapolation) auf Basis einer Mehrzahl von Halbleiterscheiben in Betracht. Dies ist insbesondere bei der DSP-Bearbeitung, also dem ersten Poliervorgang, zweckmäßig, da auf diese Weise der Messaufwand deutlich reduziert werden kann, während durch eine Inter- bzw. Extrapolation dennoch hinreichend genaue Werte erhalten werden können.

Es wird auch der Ist-Zustand der Bearbeitungsvorrichtung berücksichtigt, mit der der jeweilige Bearbeitungsvorgang durchgeführt wird. Vorzugsweise wird zu diesem Zweck der wenigstens eine Scheibenparameter, der an der zu bearbeitenden Halbleiterscheibe ermittelt wird, nach Durchlaufen des jeweiligen Bearbeitungsvorgangs wieder ermittelt. Der wieder ermittelte Scheibenparameter wird dann mitberücksichtigt, wenn es darum geht, für die Bearbeitung einer nachfolgenden Halbleiterscheibe den wenigstens einen zugehörigen Betriebsparameter des jeweiligen Bearbeitungsvorgangs vorzugeben. Grundlage des Vorgebens des wenigstens einen Betriebsparameters kann auch ein Scheibenparameter sein, der an Hand einer Anzahl zuvor bearbeiteter Halbleiterscheiben ermittelt wurde. So können also beispielsweise etwaige Abnutzungserscheinungen oder andere, insbesondere messbare, Veränderungen einer Bearbeitungsvorrichtung, die sich auf die Bearbeitung der Halbleiterscheibe auswirken, gezielt berücksichtigt werden, um so die insgesamt erreichbare Ebenheit der Halbleiterscheibe zu verbessern.

Vorteilhafterweise wird für den zweiten Poliervorgang (also für das CMP) der wenigstens eine Betriebsparameter derart vorgegeben, dass in radialer Richtung Bereiche der Halbleiterscheibe bei der Bearbeitung unterschiedlich stark beeinflusst werden, insbesondere radial weiter außenliegende Bereiche der Halbleiterscheibe stärker als radial weiter innen liegende Bereiche. Dies kann jeweils insbesondere durch Vorgabe unterschiedlicher Drücke auf die Bereiche der Halbleiterscheibe erfolgen. Solche unterschiedlichen Drücke können dabei beispielsweise durch einen geeignet ausgebildeten Träger (oder Polierstempel) der zugehörigen Bearbeitungsvorrichtung, durch den der Druck auf die Halbleiterscheibe ausgeübt wird, erzeugt werden. Es kann also der Druck für einzelne Bereiche der Halbleiterscheibe gezielt vorgegeben werden. Es lassen sich dabei Rezepte (für die Betriebsparameter) individuell für jede Halbleiterscheibe vorgeben, die zudem auch materialspezifisch (beispielsweise für das Material der Halbleiterscheibe)und spezifisch für die jeweilige Bearbeitungsvorrichtung sind (beispielsweise der Zustand des Poliertuchs) sein können.

Der wenigstens eine Betriebsparameter, der zum zweiten Poliervorgang gehört und eingestellt wird, wird vorzugsweise aus einer Gruppe ausgewählt, die eine radiale Verteilung eines Polierdrucks, eine Polierdauer, eine Drehgeschwindigkeit eines Poliertellers, eine Drehgeschwindigkeit eines Trägers, eine Zusammensetzung eines Poliermittels , einen Volumenstrom des Poliermittels, einen pH-Wert des Poliermittels eine Temperatur des Poliertellers, eine Temperatur des Poliermittels und ein Abrichten (dressing) eines Poliertuchs umfasst.

Es ist von Vorteil, wenn der Beschichtungsvorgang umfasst, dass vor Durchleiten eines Abscheidegases durch eine Beschichtungsvorrichtung, in dem die Halbleiterscheibe angeordnet ist, ein Ätzgas durch die Beschichtungsvorrichtung geleitet wird, und wobei durch den wenigstens einen Betriebsparameter ein Maß für den Fluss (z.B. Volumenstrom, Massenstrom, Ätz- bzw. Abscheidezeit o.ä.) des Abscheidegases und/oder des Ätzgases vorgegeben wird. Damit lässt sich die Beschichtung sehr genau beeinflussen, wobei durch das vorausgehende Durchleiten von Ätzgas etwaige Ablagerungen, die beispielsweise den Gasfluss und die Temperaturverteilung auf der Halbleiterscheibe und damit die Beschichtung der Halbleiterscheiben beeinflussen, zumindest teilweise entfernt werden können. Denkbar ist dabei insbesondere auch, die Dauer, während welcher das Ätzgas und/oder das Abscheidegas durchgeleitet werden, als Betriebsparameter zu wählen. Das Ätzgas besteht vorzugsweise aus einer Mischung von Chlorwasserstoff und Wasserstoff, wobei das Ätzgas auch nur aus Chlorwasserstoff oder nur aus Wasserstoff bestehen kann.

Der wenigstens eine Betriebsparameter, der zum Beschichtungsvorgang gehört und eingestellt wird, wird vorzugsweise aus einer Gruppe ausgewählt, die einen Volumenstrom eines Abscheidegases, eine Temperatur des Abscheidegases, eine Zusammensetzung des Abscheidegases, eine Dauer des Abscheidens der epitaktischen Schicht, eine Drehgeschwindigkeit eines Suszeptors und eine Verteilung von Heizleistung zum Erhitzen der Halbleiterscheibe umfasst, und zusätzlich, falls der Beschichtungsvorgang vor dem Abscheiden der epitaktischen Schicht einen Ätzvorgang umfasst, einen Volumenstrom eines Ätzgases, eine Temperatur des Ätzgases, eine Zusammensetzung des Ätzgases und eine Dauer des Ätzvorgangs.

Weitere Vorteile und Ausgestaltungen der Erfindung ergeben sich aus der Beschreibung und der beiliegenden Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen, die jeweils in den Ansprüchen definiert ist.

Die Erfindung ist anhand eines Ausführungsbeispiels in der Zeichnung schematisch dargestellt und wird im Folgenden unter Bezugnahme auf die Zeichnung beschrieben.

Figurenbeschreibung
- Figur 1: zeigt schematisch eine erfindungsgemäße Anlage in einer bevorzugten Ausführungsform, mit welcher ein erfindungsgemäßes Verfahren durchführbar ist.
- Figur 2: zeigt schematisch eine erste Poliervorrichtung, wie sie im Rahmen eines erfindungsgemäßen Verfahrens verwendet werden kann.
- Figur 3: zeigt schematisch eine zweite Poliervorrichtung, wie sie im Rahmen eines erfindungsgemäßen Verfahrens verwendet werden kann.
- Figur 4: zeigt schematisch eine Beschichtungsvorrichtung, wie sie im Rahmen eines erfindungsgemäßen Verfahrens verwendet werden kann.
- Figur 5: zeigt schematisch einen Ablauf eines erfindungsgemäßen Verfahrens in einer bevorzugten Ausführungsform.
- Figur 6: zeigt vereinfacht Messergebnisse bei Halbleiterscheiben nach Durchführung des ersten Poliervorgangs und des zweiten Poliervorgangs im Sinne der Erfindung.
- Figur 7: zeigt vereinfacht Messergebnisse an Halbleiterscheiben nach dem Beschichtungsvorgang (epiₒᵤₜ) und nach dem zweiten Poliervorgang (CMPᵢₙ), wobei auf eine aktive Steuerung des Beschichtungsvorgangs im Sinne der Erfindung verzichtet wurde.
- Figur 8: zeigt vereinfacht Messergebnisse an Halbleiterscheiben nach dem Beschichtungsvorgang (epiₒᵤₜ) und nach dem zweiten Poliervorgang (CMPᵢₙ), wobei eine aktive Steuerung des Beschichtungsvorgangs im Sinne der Erfindung durchgeführt wurde.
- Figur 9: zeigt eine Prinzip-Darstellung des erfindungsgemäßen Verfahrens.

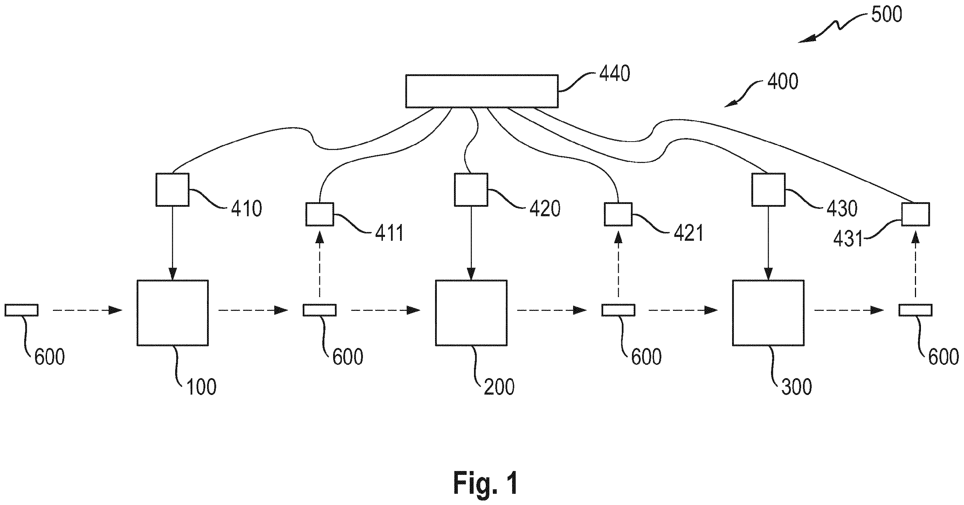

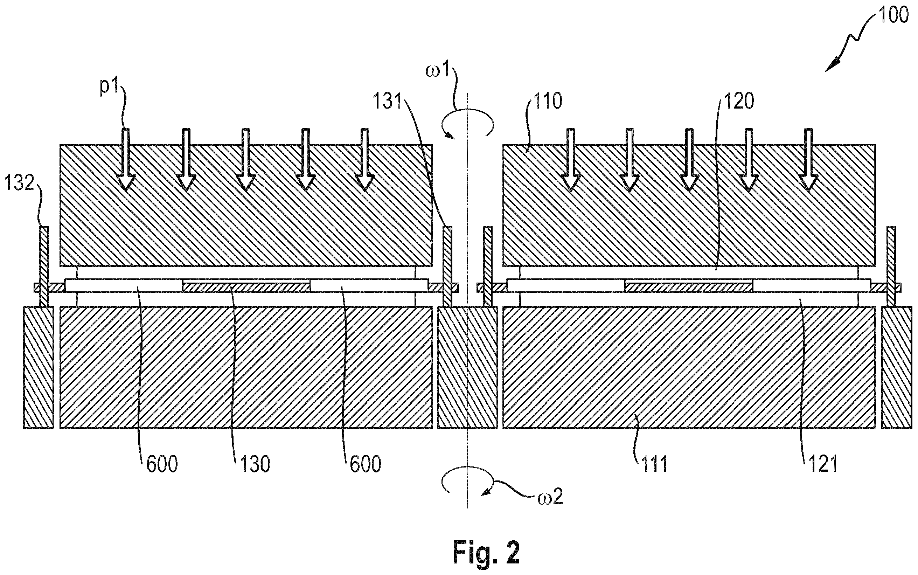

In Figur 1 ist schematisch eine erfindungsgemäße Anlage 500 in einer bevorzugten Ausführungsform dargestellt, mit der ein erfindungsgemäßes Verfahren durchführbar ist. Die Anlage 500 dient zum Bearbeiten von einer Halbleiterscheiben 600 und umfasst eine erste Poliervorrichtung 100, eine zweite Poliervorrichtung 200 und eine Beschichtungsvorrichtung 300. Diese drei Bearbeitungsvorrichtungen dienen der Bearbeitung von Halbleiterscheiben 600, die nacheinander die einzelnen Bearbeitungsvorrichtungen durchlaufen können. Der Vollständigkeit halber sei an dieser Stelle nochmals erwähnt, dass vor, zwischen und/oder nach den gezeigten und im Rahmen der Erfindung relevanten Bearbeitungsvorrichtungen auch weitere Bearbeitungsvorrichtungen vorgesehen sein können, die jedoch für die vorliegenden Erfindung nicht oder zumindest kaum relevant sind. Für eine detailliertere Beschreibung der einzelnen Bearbeitungsvorrichtungen sei an dieser Stelle auf die Figuren 2 bis 4 verwiesen.

Weiterhin umfasst die Anlage 500 ein Steuerungssystem 400, das zusammen mit den drei gezeigten Bearbeitungsvorrichtungen verwendet werden kann, um diese anzusteuern bzw. zu betreiben. Im gezeigten Beispiel umfasst das Steuerungssystem 400 drei einzelne Steuereinheiten 410, 420 und 430, die jeweils zur Ansteuerung bzw. zum Betrieb einer der drei Bearbeitungsvorrichtungen vorgesehen sind. Über die jeweilige Steuereinheit kann dabei insbesondere jeweils wenigstens ein Betriebsparameter für die jeweilige Bearbeitungsvorrichtung vorgegeben bzw. eingestellt werden.

Zu jeder der Steuereinheiten 410, 420 und 430 ist zudem jeweils eine Messvorrichtung 411, 421 bzw. 431 vorgesehen. Mittels dieser Messvorrichtungen kann eine Halbleiterscheibe, nachdem sie in der jeweiligen Bearbeitungsvorrichtung bearbeitet wurde, hinsichtlich wenigstens eines Scheibenparameters vermessen werden. Für die erste Poliervorrichtung 100 ist vorgesehen, dort mehrere Halbleiterscheiben zusammen zu polieren. Es versteht sich, dass solche Messvorrichtungen - je nach Anwendung - auch in die jeweilige Steuereinheit integriert sein können.

Zudem ist hier eine zentrale Steuereinheit 440 dargestellt, die mit jeder der Steuereinheiten 410, 420 und 430 und mit jeder der Messvorrichtungen 411, 421 und 431 verbunden ist. Eine solche Verbindung umfasst dabei zumindest eine Verbindung zur Datenübertragung, beispielsweise drahtgebunden oder drahtlos. Die von den einzelnen Messvorrichtungen 411, 421 bzw. 431 ermitteln Werte können auf diese Weise an die zentrale Steuereinheit 440 übertragen werden, sodass mittels der zentralen Steuereinheit 440 dann geeignete Betriebsparameter für die jeweiligen Bearbeitungsvorrichtungen ermittelt werden kann, welche dann an die jeweilige Steuereinheit 410, 420 bzw. 430 übertragen werden kann. Es versteht sich, dass die Ermittlung der jeweiligen Betriebsparameter auch auf andere Weise, beispielsweise direkt in einer der einzelnen Steuereinheiten, erfolgen kann.

In Figur 2 ist schematisch und detaillierter als in Figur 1 eine erste Poliervorrichtung 100 (für DSP) in einer bevorzugten Ausführungsform, wie sie im Rahmen eines erfindungsgemäßen Verfahrens verwendet werden kann, im Querschnitt dargestellt. Hierbei sind vier Halbleiterscheiben 600 (wovon nur zwei in der linken Hälfte mit einem Bezugszeichen versehen sind) in entsprechende Aussparungen von Läuferscheiben 130, die mittels eines inneren Zahnkranzes 131 und eines äußeren Zahnkranzes 132, einer sog. Abwälzvorrichtung, bewegt werden, zwischen einem oberen Polierteller 110 und einem unteren Polierteller 111 eingebracht.

Auf dem unteren Polierteller 111 befindet sich ein Poliertuch 121. Auf dem oberen Polierteller 110 befindet sich ein Poliertuch 120. Der Polierteller 110 wird zusammen mit dem Poliertuch 120 in Richtung des Polier-bzw. Anpressdruckes p1 gegen die Läuferscheiben 130, die Halbleiterscheiben 600 und den unteren Polierteller 111 mit dem Poliertuch 111 gedrückt. Dieser Polier- bzw. Anpressdruck p1 (auch zeitvariabel p1(t)) kommt beispielsweise als Betriebsparameter für die erste Poliervorrichtung in Frage. Der Vollständigkeit halber sei an dieser Stelle noch angemerkt, dass die den Halbleiterscheiben 600 zugewandten Flächen der Polierteller 110 bzw. 111 ringförmig sind.

Als weitere Betriebsparameter kommen die Rotationsgeschwindigkeiten ω1 und ω2 in Frage, mit der der obere Polierteller 110 bzw. der untere Polierteller 111 gedreht bzw. rotiert werden können. Hier sind die beiden Rotationsgeschwindigkeiten entgegengesetzt dargestellt, diese können jedoch beispielsweise und je nach Anwendung auch die gleiche Rotationsrichtung, aber unterschiedliche Beträge aufweisen. Ebenso ist es denkbar, die Rotationsgeschwindigkeiten während des Betriebs - ebenso wie den Anpress- bzw. Polierdruck - zu verändern (d.h. zeitvariabel ω1(t) bzw. ω2(t)) und/oder die Zusammensetzung des Poliermittels und/oder die Polierzeit zu verändern.

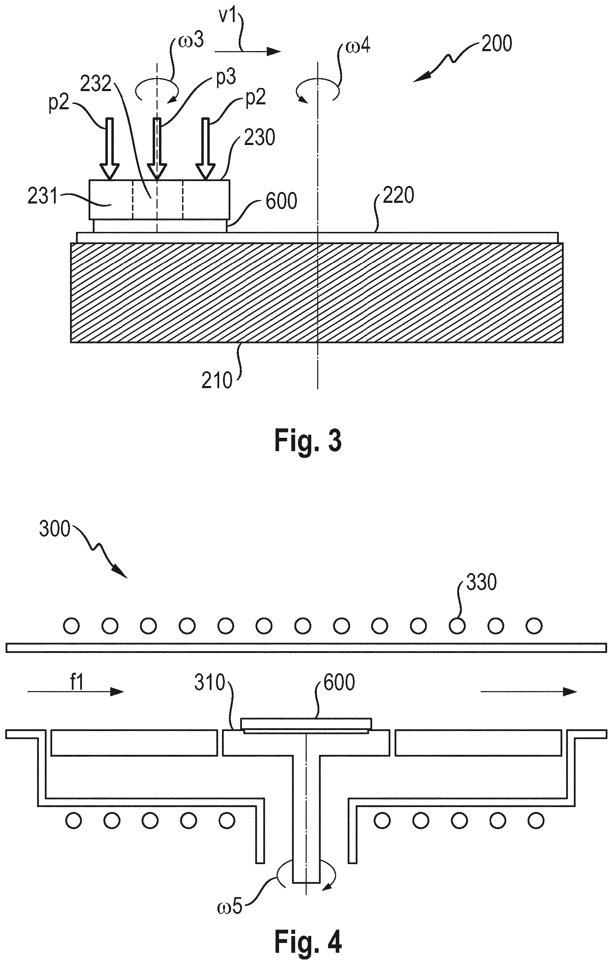

In Figur 3 ist schematisch und detaillierter als in Figur 1 eine zweite Poliervorrichtung 200 (für CMP) in einer bevorzugten Ausführungsform, wie sie im Rahmen eines erfindungsgemäßen Verfahrens verwendet werden kann, im Querschnitt dargestellt. Die Halbleiterscheibe 600 ist hier auf einem Poliertuch 220 aufgebracht, welches wiederum an einem Polierteller 210 angeordnet ist. Mittels eines Trägers 230 wird die Halbleiterscheibe 600 dabei auf das Poliertuch 220 gedrückt. Während des Polierens kann der Träger 230 dabei beispielsweise sowohl um eine erste Achse mit der Rotationsgeschwindigkeit ω3 als auch um eine zweite Achse mit der Rotationsgeschwindigkeit ω4 rotiert werden. Zudem kann der Träger mit einer Radialgeschwindigkeit v1 bewegt werden (sowohl nach innen als auch nach außen). Zum Polieren kann dabei ein geeignetes Poliermittel auf die Poliertücher aufgebracht werden.

Insbesondere ist zudem vorgesehen, dass mittels des Trägers 230 die auf die Halbleiterscheibe 600 ausübbaren Drücke unterschiedlich für unterschiedliche Bereiche eingestellt werden können. Im gezeigten, vereinfachten Beispiel kann ein Druck p2 im radial äußeren Bereich 231 und ein Druck p3 im radial inneren Bereich 232 ausgeübt werden. Insbesondere diese Drücke p2 und p3 kommen dabei als Betriebsparameter für die zweite Poliervorrichtung in Frage. Ebenso denkbar ist es, sowohl die Rotationsgeschwindigkeiten ω3 und ω4 als auch die Radialgeschwindigkeit v1 zusätzlich oder alternativ als Betriebsparameter zu verwenden. Gegebenenfalls kann stattdessen oder zusätzlich eine veränderte Zusammensetzung des Poliermittels und/oder eine veränderte Polierzeit vorgegeben werden. Auch all diese genannten Parameter können gewünschtenfalls zeitvariabel vorgebbar sein.

Die Drücke können dabei so gewählt werden, dass beispielsweise der Druck p2 größer als der Druck p3 ist. Insbesondere können die Drücke aber auch gezielt hinsichtlich ihres Betrags vorgegeben werden. Es versteht sich, dass in radialer Richtung auch noch mehr unterschiedliche Bereiche vorgesehen sein können, bei denen der Druck individuell einstellbar ist.

In Figur 4 ist schematisch und detaillierter als in Figur 1 eine Beschichtungsvorrichtung 300 in einer bevorzugten Ausführungsform, hier als Gasphasen-Epitaxie-Reaktor, wie sie im Rahmen eines erfindungsgemäßen Verfahrens verwendet werden kann, im Querschnitt dargestellt. In der Mitte der Beschichtungsvorrichtung 300 befindet sich ein Suszeptor 310, auf welchem eine zu beschichtende Halbleiterscheibe 600 angeordnet, d.h. abgelegt werden kann. Der Suszeptor 310 weist dabei eine mittige Vertiefung auf, sodass die Halbleiterscheibe 600 beispielsweise nur im Bereich weniger Millimeter ihres Randes auf dem Suszeptor 310 aufliegt.

Durch den Epitaxie-Reaktor 300 kann Gas geleitet werden, im vorliegenden Beispiel von einer Öffnung auf der linken Seite bis zu einer Öffnung auf der rechten Seite des Epitaxie-Reaktors 300, wie dies durch zwei Pfeile angedeutet ist. Mittels Wärmeerzeugungsmitteln, bspw. Heizlampen 330 auf der oberen und der unteren Seite des Epitaxie-Reaktors 300, von denen beispielhaft eine mit einem Bezugszeichen versehen ist, können das durch den Epitaxie-Reaktor 300 geleitete Gas und die Halbleiterscheibe je nach Bedarf auf eine gewünschte Temperatur gebracht werden.

Zum Beschichten einer Halbleiterscheibe 600 wird nun ein Abscheidegas, bspw. Trichlorsilan, ggf. gemischt mit Wasserstoff, durch den Epitaxie-Reaktor 300 geleitet. Volumenstrom f1 und/oder Zeitdauer des Durchleitens und/oder Temperatur können hierbei beispielsweise je nach gewünschter Dicke der epitaktisch abzuscheidenden Schicht auf der Halbleiterscheibe 600 als Betriebsparameter eingestellt werden. Zudem kann der Suszeptor 310 mit der darauf angeordneten Halbleiterscheibe 600 mit einer vorgebbaren Rotationsgeschwindigkeit ω5, die alternativ oder zusätzlich ebenfalls als Betriebsparameter in Frage kommt, um eine Achse rotiert werden, wie dies in der Figur angedeutet ist. Auf diese Weise kann ein gleichmäßiges Abscheiden der epitaktischen Schicht erreicht werden. Gegebenenfalls kann stattdessen oder zusätzlich eine veränderte radiale Temperaturverteilung vorgegeben werden. Auch all diese genannten Parameter können gewünschtenfalls zeitvariabel vorgebbar sein.

Im Rahmen eines Beschichtungsvorgangs kann vor dem Durchleiten des Abscheidegases in einem Ätzvorgang ein Ätzgas, das Material von der Halbleiterscheibe abträgt, durch den Epitaxie-Reaktor 300 geleitet werden, so dass die Halbleiterscheibe vor dem eigentlichen Beschichtungsvorgang gezielt vorbehandelt wird.

Bevorzugt kann dabei ein Volumenstrom des ersten Ätzgases auf 4 slm und der Gasfluss des Trägergases auf 50 slm eingestellt werden (dabei steht slm für Standard-Liter pro Minute).

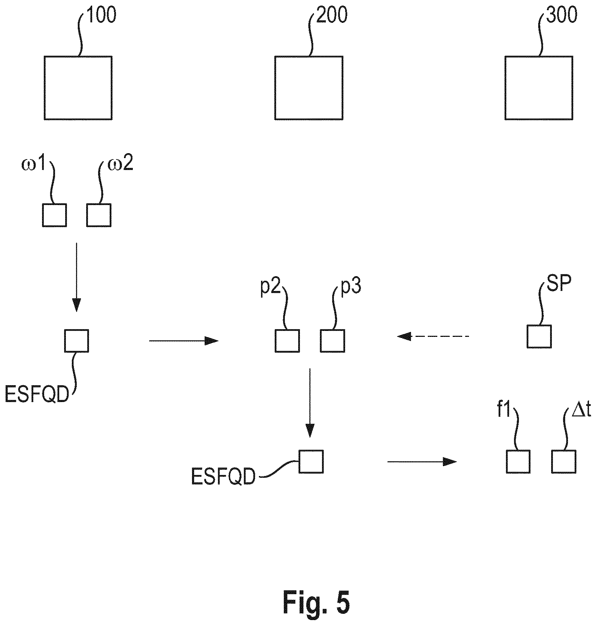

In Figur 5 ist schematisch ein Ablauf eines erfindungsgemäßen Verfahrens in einer bevorzugten Ausführungsform dargestellt. Zunächst werden für mehrere Halbleiterscheiben in der ersten Poliervorrichtung 100 beispielhaft die Betriebsparameter ω1 und ω2 für die Rotationsgeschwindigkeiten vorgegeben. Nach Durchlaufen des ersten Poliervorgangs wird dann für jede der Halbleiterscheiben hier der ESFQDₐᵥ-Wert als Scheibenparameter ermittelt. Wie bereits erwähnt, kann dies bei der ersten Poliervorrichtung durch Inter- bzw. Extrapolation basierend auf Werten von mehreren Halbleiterscheiben erfolgen.

Basierend auf dem hierbei ermittelten ESFQDₐᵥ-Wert werden dann bei der zweiten Poliervorrichtung 200 beispielhaft die Betriebsparameter p2 und p3, also die Drücke, mit denen die Halbleiterscheibe mittels des Trägers in verschiedenen Bereichen auf das Poliertuch gedrückt wird, vorgegeben. Des Weiteren werden nach Durchlaufen der drei Bearbeitungsvorgänge ESFQRₘₐₓ, SFQRₘₐₓ, ZDDₐᵥ und GBIR der bearbeiteten Halbleiterscheibe ermittelt und überprüft, ob jeder der Scheibenparameter SP in einem zugehörenden gewünschten Zielwert-Bereich liegt oder einem gewünschten Zielwert entspricht. Insbesondere ein Verfehlen eines Zielwert-Bereichs wird zum Anlass genommen, wenigstens einen Betriebsparameter wenigstens eines der drei Bearbeitungsvorgänge für eine nachfolgende Halbleiterscheibe zu verändern. Beispielsweise kann das dazu führen, veränderte Betriebsparameter p2 und p3 vorzugeben. Auf diese Weise können eine Wechselwirkung zwischen dem zweiten Poliervorgang und dem Beschichtungsvorgang besonders gut berücksichtigt werden und so die Ebenheit der Halbleiterscheiben deutlich verbessert werden.

Basierend auf dem ermittelten ESFQDₐᵥ-Wert können bei der Beschichtungsvorrichtung 300 beispielhaft die Betriebsparameter f1 und Δt für den Volumenstrom von Ätzgas und der zugehörigen Zeitdauer vorgegeben werden. Denkbar ist auch die Vorgabe von Volumenstrom und/oder zugehöriger Zeitdauer von Abscheidegas. Insgesamt werden also Betriebsparameter verschiedener Bearbeitungsvorgänge bzw. Bearbeitungsvorrichtungen in Abhängigkeit voneinander vorgegeben.

Der Vollständigkeit halber sei an dieser Stelle noch angemerkt, dass der gezeigte und beschriebene Ablauf nur beispielhaft ist und auch andere Betriebsparameter und ggf. auch andere Scheibenparameter (jeweils sowohl hierin erwähnte als auch andere mögliche Betriebsparameter) eingestellt bzw. berücksichtigt werden können.

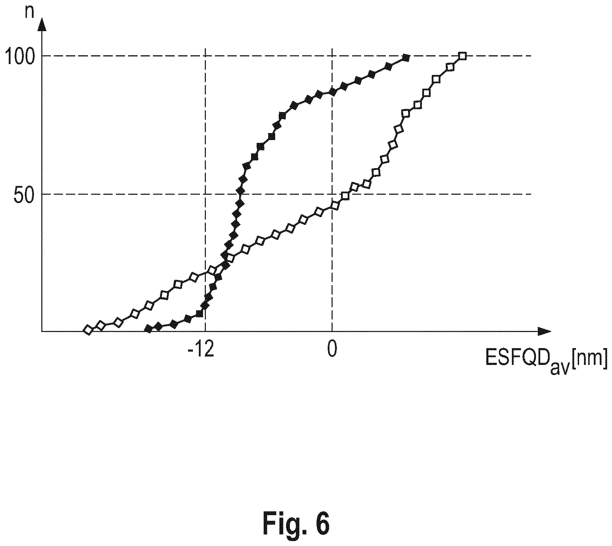

In Figur 6 sind vereinfacht Messergebnisse bei Halbleiterscheiben nach Durchführung des ersten Poliervorgangs und des zweiten Poliervorgangs dargestellt. Hierzu ist die Anzahl n der bearbeiteten Halbleiterscheiben in kumulierten Prozent gegenüber dem ESFQDₐᵥ-Wert aufgetragen und zwar einmal nach Durchlaufen der ersten Poliervorrichtung und vor Durchlaufen der zweiten Poliervorrichtung (mit offenen Rauten) und einmal nach Durchlaufen der zweiten Poliervorrichtung und vor Durchlaufen der Beschichtungsvorrichtung (mit geschlossenen Rauten).

Zudem ist ein Bereich für den ESFQDₐᵥ-Wert von -12 bis 0 nm eingezeichnet, weil die Durchführung des erfindungsgemäßen Verfahrens zur Erkenntnis führt, etwas weniger als die Mitte dieses Bereichs anzustreben, um ESFQRₘₐₓ, SFQRₘₐₓ, ZDDₐᵥ und GBIR nach Durchlaufen der drei Bearbeitungsvorgänge im jeweils gewünschten Zielwert-Bereich zu erhalten. Eine Strategie, die sich darauf beschränkte, die einzelnen Bearbeitungsvorgänge zu optimieren, würde Betriebsparameter mit dem Ziel vorgeben, einen ESFQDₐᵥ-Wert der Halbleiterscheiben möglichst nahe bei 0 nm nach dem ersten und dem zweiten Poliervorgang zu erreichen.

Durch Vorgeben wenigstens eines Betriebsparameters für den zweiten Poliervorgang entsprechend der Erfindung gelingt es, den ESFQDₐᵥ-Wert vorwiegend im angestrebten Bereich zu erhalten. Während nach dem ersten Poliervorgang nur ca. 25% der Halbleiterscheiben im angestrebten Bereich liegen, liegen nach Durchlaufen des zweiten Poliervorgangs ca. 80% der Halbleiterscheiben in diesem gewünschten Bereich. Dies zeigt, dass durch die Berücksichtigung von wenigstens einem ermittelten Scheibenparameter nach dem ersten Poliervorgang und darauf basierend durch Vorgabe von wenigstens einem Betriebsparameter für den zweiten Poliervorgang etwaige Abweichungen sehr gut kompensiert werden können. Insbesondere hat sich gezeigt, dass auch bis zu ca. 90% und mehr von in dem gewünschten Bereich liegenden Halbleiterscheiben erreicht werden können.

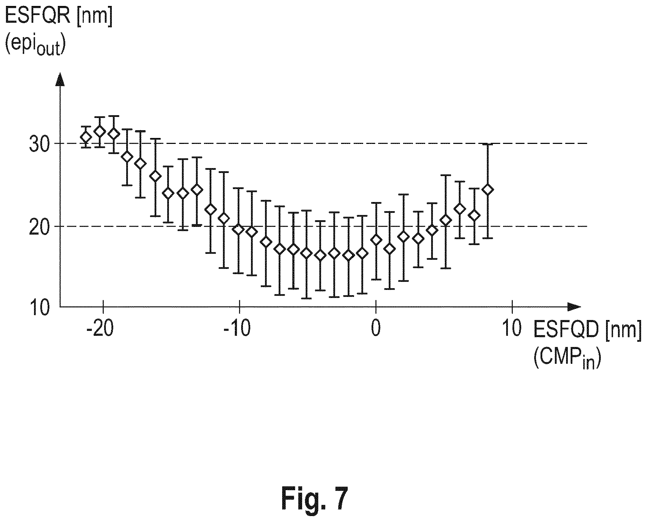

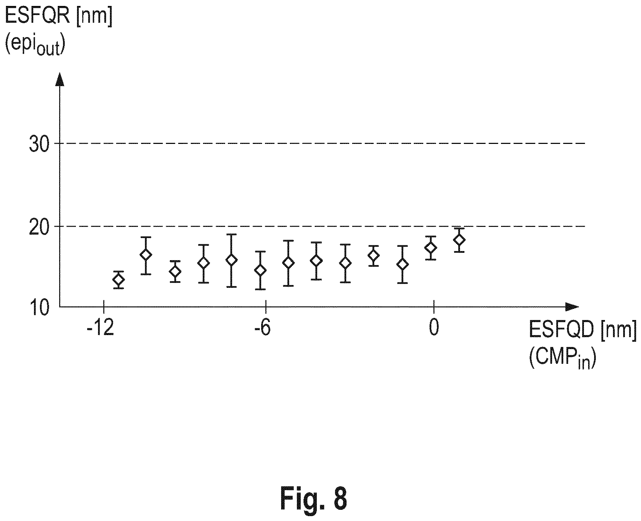

Figur 7 und Figur 8 zeigen jeweils vereinfacht Messergebnisse an Halbleiterscheiben nach Durchführung des Beschichtungsvorgangs (epiₒᵤₜ) und nach dem zweiten Poliervorgang (CMPᵢₙ). Es wurde - darauf beschränkt - die Wirkung untersucht, die eine erfindungsgemäße Steuerung des Beschichtungsvorgangs im Vergleich zu deren Unterlassen hat. Wird auf eine erfindungsgemäße Steuerung des Beschichtungsvorgangs verzichtet, und bleiben insbesondere Beschichtungsabweichungen aufgrund der Vierfach-Symmetrie außer Betracht, wird nur ein vergleichsweise geringer Anteil an Halbleiterscheiben, nämlich nur diejenigen mit einem ESFQDₐᵥ im Bereich von etwa -1 nm bis etwa -6 nm, die besten Resultate in Bezug auf den ESFQRₘₐₓ-Wert in nm nach Durchlauf der drei Bearbeitungsvorgänge erzielen (Fig.7). Im Vergleich dazu ist zu erwarten, dass alle Halbleiterscheiben mit einem ESFQDₐᵥ im Bereich von etwa - 12 nm bis etwa + 3 nm vergleichbare Resultate hinsichtlich des ESFQRₘₐₓ-Werts erzielen (Fig.8).

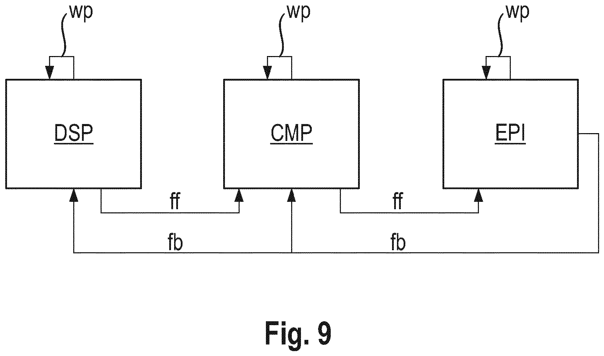

Figur 9 zeigt zusammenfassend das Prinzip des erfindungsgemäßen Verfahrens.

Für jeden der drei Bearbeitungsvorgänge wird Information bereitgestellt, um wenigstens einen Betriebsparameter, der für die jeweilige Bearbeitungsvorrichtung spezifisch ist, vorgeben zu können:
Es wird wenigstens ein Scheibenparameter an der zu bearbeitenden Halbleiterscheibe ermittelt, um mindestens einen Betriebsparameter für den nachfolgenden Bearbeitungsvorgang vorzugeben (cross-process feed forward, ff).
Es wird der Ist-Zustand der jeweiligen Bearbeitungsvorrichtung beurteilt, und darauf basierend wird mindestens ein Betriebsparameter der beurteilten Bearbeitungsvorrichtung für die Bearbeitung einer nachfolgenden Halbleiterscheibe mit dieser Bearbeitungsvorrichtung vorgegeben (within process feed back, wp).

Nach Durchlauf der drei Bearbeitungsvorgänge werden ESFQRₘₐₓ, SFQRₘₐₓ, ZDDₐᵥ und GBIR der bearbeiteten Halbleiterscheibe betrachtet und mit jeweiligen Zielwerten verglichen, um mindestens einen Betriebsparameter für einen oder mehrere der drei Bearbeitungsvorgänge zur Bearbeitung einer nachfolgenden Halbleiterscheibe vorzugeben (cross-process feedback, fb).

Die Wirkung der Erfindung wurde auch praktisch getestet. Es wurden Halbleiterscheiben aus einkristallinem Silizium mit einer epitaktischen Schicht aus einkristallinem Silizium nach dem erfindungsgemäßen Verfahren hergestellt. Die Halbleiterscheiben hatten {100}-Orientierung und einen Durchmesser von 300 mm, und die epitaktische Schicht hatte eine Dicke von 2,75 µm. Die nachfolgende Tabelle listet Eigenschaften zweier Vertreter der erzeugten Halbleiterscheiben auf. DT/DG bezeichnen den Dotierstoff-Typ beziehungsweise den Dotierstoff-Grad der Halbleiterscheibe (HS) beziehungsweise der epitaktischen Schicht (eS).

**Tabelle**

| DT/DG HS | DT/DG eS | ESFQRₘₐₓ¹⁾ | SFQRₘₐₓ²⁾ | ZDDₐᵥ³⁾ | GBIR⁴⁾ |
|---|---|---|---|---|---|
| p⁻ | p | 10 nm | 9 nm | - 6 nm/mm² | 74 nm |
| p⁺ | p | 10 nm | 8 nm | - 1 nm/mm² | 41 nm |

| | | | | | |
|---|---|---|---|---|---|
| ¹⁾ESFQRₘₐₓ bei einem Randausschluss von 2 mm, einer Randaufteilung in 72 Sektoren und einer Sektorlänge von 30 mm , bestimmt nach SEMI M67; ²⁾SFQRmax bei einem Randausschluss von 2 mm und einer Site-Fläche von 26 mm x 8 mm, bestimmt nach SEMI M1, SEMI MF 1530 und SEMI M49; ³⁾ ZDDₐᵥ an einer Radiusposition von 148 mm, bestimmt nach SEMI M68; ⁴⁾ GBIR bei einem Randausschluss von 2 mm, bestimmt nach SEMI M1, SEMI MF 1530 und SEMI 49. | | | | | |

## Patentansprüche

1. Verfahren zum Bearbeiten einer Halbleiterscheibe (600) umfassend drei Bearbeitungsvorgänge, nämlich einen ersten Poliervorgang, bei dem die Halbleiterscheibe (600) doppelseitig poliert wird, nachfolgend einen zweiten Poliervorgang, bei dem die Halbleiterscheibe (600) chemisch-mechanisch poliert wird, und nachfolgend einen Beschichtungsvorgang, bei dem auf der Halbleiterscheibe (600) epitaktisch eine Schicht abgeschieden wird,
**dadurch gekennzeichnet, dass** für jeden der drei Bearbeitungsvorgänge wenigstens ein Betriebsparameter des jeweiligen Bearbeitungsvorgangs vorgegeben wird, und zwar basierend auf wenigstens einem Scheibenparameter, der an der zu bearbeitenden Halbleiterscheibe ermittelt wird;
basierend auf einem Ist-Zustand einer Bearbeitungsvorrichtung, mit der der jeweilige Bearbeitungsvorgang durchgeführt wird; und
basierend auf einer Optimierung von Scheibenparametern zur Charakterisierung der Ebenheit hinsichtlich deren Zustands nach dem Durchlaufen der drei Bearbeitungsvorgänge an Stelle einer Optimierung dieser Scheibenparameter hinsichtlich deren Zustands nach jedem einzelnen der drei Bearbeitungsschritte.

2. Verfahren nach Anspruch 1, wobei der zu ermittelnde Scheibenparameter aus Rohdaten einer Ebenheitsmessung erhalten wird.

3. Verfahren nach Anspruch 1 oder Anspruch 2, wobei als zu ermittelnder Scheibenparameter ESFQDₐᵥ ausgewählt wird.

4. Verfahren nach einem der vorstehenden Ansprüche, wobei als Scheibenparameter zur Charakterisierung der Ebenheit ESFQRₘₐₓ, SFQRₘₐₓ, ZDDₐᵥ und GBIR betrachtet werden.

5. Verfahren nach einem der vorstehenden Ansprüche, wobei für den ersten Poliervorgang der wenigstens eine zughörige Betriebsparameter eingestellt und aus einer ersten Gruppe ausgewählt wird, die einen Polierdruck, eine Polierdauer, eine Drehgeschwindigkeit eines oberen Poliertellers, eine Drehgeschwindigkeit eines unteren Poliertellers, eine Drehgeschwindigkeit eines inneren Antriebskranzes, eine Drehgeschwindigkeit eines äußeren Antriebskranzes, eine Temperatur des oberen Poliertellers, eine Temperatur des unteren Poliertellers, eine Zusammensetzung eines Poliermittels , einen Volumenstrom des Poliermittels, eine Temperatur des Poliermittels, einen pH-Wert des Poliermittels und eine Ziel-Differenz von Zentrums-Dicke der polierten Halbleiterscheibe und mittlerer Dicke einer zum Polieren verwendeten Läuferscheibe umfasst.

6. Verfahren nach Anspruch 5, wobei der wenigstens eine Scheibenparameter, der an der zu bearbeitenden Halbleiterscheibe ermittelt wird, durch Messung an der jeweiligen Halbleiterscheibe ermittelt wird oder anhand einer Auswertung basierend auf der Messung einer Mehrzahl von zu bearbeitenden Halbleiterscheiben ermittelt wird.

7. Verfahren nach einem der vorstehenden Ansprüche, wobei für den zweiten Poliervorgang der wenigstens eine zughörige Betriebsparameter eingestellt und aus einer zweiten Gruppe ausgewählt wird, die eine radiale Verteilung eines Polierdrucks, eine Polierdauer, eine Drehgeschwindigkeit eines Poliertellers, eine Drehgeschwindigkeit eines Trägers, eine Zusammensetzung eines Poliermittels, einen Volumenstrom des Poliermittels, einen pH-Wert des Poliermittels eine Temperatur des Poliertellers, eine Temperatur des Poliermittels und ein Abrichten eines Poliertuchs umfasst.

8. Verfahren nach einem der vorstehenden Ansprüche, wobei für den Beschichtungsvorgang der wenigstens eine zugehörige Betriebsparameter eingestellt und aus einer dritten Gruppe ausgewählt wird, die einen Volumenstrom eines Abscheidegases, eine Temperatur des Abscheidegases, eine Zusammensetzung des Abscheidegases, eine Dauer des Abscheidens der epitaktischen Schicht, eine Drehgeschwindigkeit eines Suszeptors, eine Verteilung von Heizleistung zum Erhitzen der Halbleiterscheibe umfasst, und zusätzlich, falls der Beschichtungsvorgang vor dem Abscheiden der epitaktischen Schicht einen Ätzvorgang umfasst, einen Volumenstrom eines Ätzgases, eine Temperatur des Ätzgases, eine Zusammensetzung des Ätzgases und eine Dauer des Ätzvorgangs.

9. Verfahren nach Anspruch 8, wobei im Zuge des Ätzvorgangs das Ätzgas durch die Beschichtungsvorrichtung (300) geleitet wird.

10. Verfahren nach einem der vorstehenden Ansprüche, wobei für wenigstens einen der Bearbeitungsvorgänge wenigstens ein zugehöriger Betriebsparameter basierend auf einem gewünschten Wert des wenigstens einen Scheibenparameters nach Durchlaufen wenigstens eines nachfolgenden der Bearbeitungsvorgänge vorgegeben wird.

11. Verfahren nach einem der vorstehenden Ansprüche, wobei für den zweiten Poliervorgang der wenigstens eine Betriebsparameter (p2, p3) derart vorgegeben wird, dass in radialer Richtung der Halbleiterscheibe (600) Bereiche bei der Bearbeitung unterschiedlich poliert werden, und zwar durch Vorgabe unterschiedlicher Drücke (p2, p3) auf die Bereiche der Halbleiterscheibe (600).

12. Halbleiterscheibe (600), insbesondere Siliziumscheibe, mit einem ESFQRₘₐₓ-Wert bei einem Randausschluss von 2 mm, einer Randaufteilung in 72 Sektoren und einer Sektorlänge von 30 mm von nicht größer als 10 nm, einem SFQRₘₐₓ-Wert bei einem Randausschluss von 2 mm und einer Site-Fläche von 26 mm x 8 mm von nicht größer als 10 nm, einem ZDDₐᵥ-Wert an einer Radiusposition von 148 mm mit einem Betrag von nicht größer als 10 nm/mm² und einem GBIR-Wert bei einem Randausschluss von 2 mm von nicht größer als 0,10 µm.

## Claims

1. A method for processing a semiconductor wafer (600) comprising three processing operations, namely a first polishing operation in which the semiconductor wafer (600) is polished on both sides, subsequently a second polishing operation in which the semiconductor wafer (600) is polished chemically and mechanically, and subsequently a coating operation in which a layer is deposited epitaxially on the semiconductor wafer (600),
**characterized in that** for each of the three machining operations at least one operating parameter of the respective machining operation is predetermined, namely
based on at least one wafer parameter determined on the semiconductor wafer to be processed; based on an actual state of a processing device with which the respective processing operation is performed; and
based on optimization of disk parameters for characterization of flatness with respect to their state after passing through the three machining operations instead of optimization of these disk parameters with respect to their state after each of the three machining operations.

2. The method according to claim 1, wherein the disk parameter to be determined is obtained from raw data of a flatness measurement.

3. The method according to claim 1 or claim 2, wherein ESFQDₐᵥ is selected as the slice parameter to be determined.

4. The method according to any of the preceding claims, wherein ESFQRₘₐₓ , SFQRₘₐₓ , ZDDₐᵥ and GBIR are considered as slice parameters for characterizing flatness.

5. The method according to any one of the preceding claims, wherein for the first polishing operation the at least one associated operating parameter is set and selected from a first group comprising a polishing pressure, a polishing duration, a rotational speed of an upper polishing pad, a rotational speed of a lower polishing pad, a rotational speed of an inner drive ring, a rotational speed of an outer drive ring, a temperature of the upper polishing plate, a temperature of the lower polishing plate, a composition of a polishing agent, a volumetric flow rate of the polishing agent, a temperature of the polishing agent, a pH of the polishing agent, and a target difference of center thickness of the polished semiconductor wafer and average thickness of a rotor wafer used for polishing.

6. The method according to claim 5, wherein the at least one wafer parameter determined on the semiconductor wafer to be processed is determined by measurement on the respective semiconductor wafer or is determined by means of an evaluation based on the measurement of a plurality of semiconductor wafers to be processed.

7. The method according to any one of the preceding claims, wherein for the second polishing operation the at least one associated operating parameter is set and selected from a second group comprising a radial distribution of a polishing pressure, a polishing duration, a rotational speed of a polishing plate, a rotational speed of a carrier, a composition of a polishing agent, a volumetric flow rate of the polishing agent, a pH of the polishing agent, a temperature of the polishing plate, a temperature of the polishing agent, and a dressing of a polishing cloth.

8. The method according to any one of the preceding claims, wherein for the coating process the at least one associated operating parameter is set and selected from a third group comprising a volumetric flow rate of a deposition gas, a temperature of the deposition gas, a composition of the deposition gas, a duration of deposition of the epitaxial layer, a rotational speed of a susceptor, a distribution of heating power for heating the semiconductor wafer, and additionally, if the deposition process comprises an etching process prior to deposition of the epitaxial layer, a volumetric flow rate of an etching gas, a temperature of the etching gas, a composition of the etching gas, and a duration of the etching process.

9. The method of claim 8, wherein in the course of the etching process, the etching gas is passed through the coating device (300).

10. The method according to any one of the preceding claims, wherein for at least one of said machining operations at least one associated operating parameter is predetermined based on a desired value of said at least one disk parameter after passing through at least a subsequent one of said machining operations.

11. The method according to one of the preceding claims, wherein for the second polishing process the at least one operating parameter (p2, p3) is preset in such a way that areas in the radial direction of the semiconductor wafer (600) are polished differently during processing, specifically by presetting different pressures (p2, p3) to the areas of the semiconductor wafer (600).

12. A Semiconductor wafer (600), especially silicon wafer, having an ESFQRₘₐₓ value at an edge exclusion of 2 mm, an edge division into 72 sectors and a sector length of 30 mm of not greater than 10 nm, an SFQRₘₐₓ value at an edge exclusion of 2 mm and a site area of 26 mm x 8 mm of not greater than 10 nm, a ZDDₐᵥ value at a radius position of 148 mm with a magnitude of not greater than 10 nm/mm² and a GBIR value at an edge exclusion of 2 mm of not greater than 0.10 µm.

## Revendications

1. Procédé de traitement d'une plaquette semi-conductrice (600) comprenant trois opérations de traitement, à savoir une première opération de polissage, dans laquelle la plaquette semi-conductrice (600) est polie des deux côtés, suivie d'une deuxième opération de polissage, dans laquelle la plaquette semi-conductrice (600) est polie chimiquement et mécaniquement, et suivie d'une opération de revêtement, dans laquelle une couche est déposée par épitaxie sur la plaquette semi-conductrice (600),
**caractérisé en ce que**, pour chacune des trois opérations de traitement, au moins un paramètre de fonctionnement de l'opération de traitement respective est prédéfini, à savoir sur la base d'au moins un paramètre de tranche déterminé sur la tranche de semi-conducteur à traiter ;
sur la base d'un état réel d'un dispositif de traitement avec lequel l'opération de traitement respective est effectuée ; et
basé sur une optimisation des paramètres de disque pour caractériser la planéité quant à son état après le passage des trois opérations de traitement, au lieu d'une optimisation de ces paramètres de disque quant à leur état après chacune des trois opérations de traitement.

2. Procédé selon la revendication 1, dans lequel le paramètre de tranche à déterminer est obtenu à partir de données brutes d'une mesure de planéité.

3. Procédé selon la revendication 1 ou la revendication 2, dans lequel on choisit comme paramètre de tranche à déterminer ESFQDₐᵥ .

4. Procédé selon l'une des revendications précédentes, dans lequel on considère comme paramètres de tranche pour caractériser la planéité ESFQRₘₐₓ , SFQRₘₐₓ , ZDDₐᵥ et GBIR .

5. Procédé selon l'une quelconque des revendications précédentes, dans lequel, pour la première opération de polissage, le au moins un paramètre de fonctionnement associé est réglé et choisi dans un premier groupe comprenant une pression de polissage, une durée de polissage, une vitesse de rotation d'un plateau de polissage supérieur, une vitesse de rotation d'un plateau de polissage inférieur, une vitesse de rotation d'une couronne d'entraînement intérieure, une vitesse de rotation d'une couronne d'entraînement extérieure, une température du plateau de polissage supérieur, une température du plateau de polissage inférieur, une composition d'un agent de polissage, un débit volumétrique de l'agent de polissage, une température de l'agent de polissage, un pH de l'agent de polissage et une différence cible entre l'épaisseur centrale de la plaquette semi-conductrice polie et l'épaisseur moyenne d'un disque de rotor utilisé pour le polissage.

6. Procédé selon la revendication 5, dans lequel le au moins un paramètre de plaquette déterminé sur la plaquette semi-conductrice à traiter est déterminé par mesure sur la plaquette semi-conductrice respective ou est déterminé à l'aide d'une évaluation basée sur la mesure d'une pluralité de plaquettes semi-conductrices à traiter.

7. Procédé selon l'une quelconque des revendications précédentes, dans lequel, pour la seconde opération de polissage, le au moins un paramètre de fonctionnement associé est réglé et choisi dans un second groupe comprenant une distribution radiale d'une pression de polissage, une durée de polissage, une vitesse de rotation d'un plateau de polissage, une vitesse de rotation d'un support, une composition d'un agent de polissage, un débit volumique de l'agent de polissage, un pH de l'agent de polissage, une température du plateau de polissage, une température de l'agent de polissage et un dressage d'un drap de polissage.

8. Procédé selon l'une quelconque des revendications précédentes, dans lequel, pour l'opération de revêtement, ledit au moins un paramètre de fonctionnement associé est réglé et choisi dans un troisième groupe comprenant un débit volumique d'un gaz de dépôt, une température du gaz de dépôt, une composition du gaz de dépôt, une durée de dépôt de la couche épitaxiale, une vitesse de rotation d'un suscepteur, une répartition de la puissance de chauffage pour chauffer la plaquette semi-conductrice, et en outre, si le processus de revêtement comprend un processus de gravure avant le dépôt de la couche épitaxiale, un débit volumique d'un gaz de gravure, une température du gaz de gravure, une composition du gaz de gravure et une durée du processus de gravure.

9. Procédé selon la revendication 8, dans lequel, au cours de l'opération de gravure, le gaz de gravure est envoyé à travers le dispositif de revêtement (300).

10. Procédé selon l'une quelconque des revendications précédentes, dans lequel, pour au moins l'une des opérations de traitement, au moins un paramètre de fonctionnement associé est prédéterminé sur la base d'une valeur souhaitée du au moins un paramètre de disque après le passage d'au moins une opération suivante des opérations de traitement.

11. Procédé selon l'une des revendications précédentes, dans lequel, pour la deuxième opération de polissage, l'au moins un paramètre de fonctionnement (p2, p3) est prédéfini de telle sorte que, dans la direction radiale de la plaquette semi-conductrice (600), des zones sont polies différemment lors du traitement, et ce en prédéfinissant des pressions différentes (p2, p3) sur les zones de la plaquette semi-conductrice (600).

12. Plaquette de semi-conducteur (600), en particulier plaquette de silicium, ayant une valeur
ESFQRₘₐₓ à une exclusion de bord de 2 mm, une division de bord en 72 secteurs et une longueur de secteur de 30 mm non supérieure à 10 nm, une valeur SFQRₘₐₓ à une exclusion de bord de 2 mm et une surface de site de 26 mm x 8 mm non supérieure à 10 nm, une valeur ZDDₐᵥ à une position de rayon de 148 mm avec une valeur non supérieure à 10 nm/mm² et une valeur GBIR à une exclusion de bord de 2 mm non supérieure à 0,10 µm.
